# DEMANDE DE BREVET EUROPEEN

(11) **EP 1 542 289 A1**
(43) Date de publication de la demande: **15.06.2005**
(21) Numéro de dépôt: 03293117.2
(22) Date de dépôt: 11.12.2003
(51) Int. Cl.: H01L 29/78

(54) **Structure MOS résistante aux radiations**

(71) Demandeur: STMicroelectronics S.A., 92120 Montrouge (FR); STMicroelectronics S.r.l., 20041 Agrate Brianza (Milano) (IT)
(72) Inventeur: Frapreau, Ivan, 35150 Janze (FR); Abella, Crispino Sergio, 95030 S. Agata Li Battiati (Catania) (IT); Mazza, Alfio, 95124 Catania (IT)
(74) Mandataire: Ferrari, Barbara

(57) **Abrégé**

Structure MOS résistante aux radiations (1, 1a) sur un substrat semi-conducteur (2, 2a) comprenant un transistor MOS (3, 3a) réalisé dans une zone active (5, 5a) entourée par une couche d'isolement (6, 6a), ledit transistor MOS (3, 3a) comprenant:
- une région de canal (9, 9a) délimitée par des régions de source (7, 7a) et drain (8, 8a) opposées d'un premier type de conductivité;
- une région de grille (10, 10a) formée sur le canal et isolée de celui-ci par une couche d'oxyde mince (11, 11a); la structure MOS résistante aux radiations (1, 1a) étant caractérisée en ce qu'elle comprend
- un élément à anneau de garde (4, 4a) d'un deuxième type de conductivité, formé dans le substrat semi-conducteur (2) sous la couche d'isolement (6, 6a), et
- lesdites régions de source (7, 7a) et drain (8, 8a) sont éloignées de ladite couche d'isolement (6, 6a).

## Description

### Domaine d'application

La présente invention concerne une technologie de circuit intégré et, plus en particulier, une technologie de circuit résistante aux radiations.

En particulier, l'invention concerne une circuiterie à semi-conducteur métal-oxyde (MOS) pour produire des dispositifs intégrés soumis à des conditions environnementales difficiles.

### Art antérieur

Les dispositifs semi-conducteurs et les circuits intégrés (CI) utilisés dans l'espace extérieur, par exemple dans un satellite, sont soumis à des conditions environnementales difficiles qui peuvent causer la dérive de paramètres électriques et/ ou une défaillance logique.

Tous les circuits intégrés utilisés dans les applications spatiales devraient être fonctionnels pour toute la durée de vie du satellite, qui peut être de plusieurs années.

Pour compliquer cette tâche il faut noter qu'il existe plusieurs formes de particules à haute énergie dans l'espace extérieur. Par exemple, il existe des particules alpha et des rayons gamma, pour ne mentionner qu'une paire de particules.

Ces particules à haute énergie frappent le matériel semi-conducteur sur lequel on a formé les dispositifs à circuit intégré MOS avec assez d'énergie pour entraîner la génération de paires électron-trou.

Les vecteurs de charge résultants sont souvent piégés dans les différentes couches d'oxyde des dispositifs. Dans le cas des transistors à semi-conducteur métal-oxyde («MOS»), les charges piégées dans l'oxyde de grille vont changer la tension de seuil Vt du transistor. Par conséquent, des courants de dispersion des transistors, et par suite, du dispositif à circuit intégré, vont affecter les performances et l'efficacité du système.

La fréquence ou le nombre des charges piégées dans une couche d'oxyde est proportionnelle à l'épaisseur de la couche d'oxyde. Par conséquent, les oxydes ayant une grande épaisseur auront, en moyenne, un nombre supérieur de charges piégées. Lorsque l'oxyde est relativement épais, par exemple environ 4000-5000 .ANG. (Angstom), la charge piégée dans l'oxyde entraînera un changement bien plus grave des caractéristiques du courant de dispersion par rapport à un transistor actif ayant un oxyde de grille relativement mince.

L'application d'un oxyde épais est spécifique pour l'isolement des zones actives du transistor dans lesquelles on peut former des cellules MOS, par exemple des régions d'oxydation locale de silicium («LOCOS»). La charge accumulée piégée dans la région LOCOS peut devenir assez importante pour entraîner la formation d'un canal de conduction sous la région LOCOS, et par conséquent elle peut permettre au courant de couler entre des régions actives adjacentes du transistor.

Comme on a déjà mentionné, les transistors dans la région active d'un dispositif à circuit intégré logique à haute vitesse, ayant traditionnellement des oxydes de grille étant bien plus minces que les oxydes de la région LOCOS, auront une tension de seuil de déplacement Vts résultant des charges piégées dans l'oxyde de grille.

Pour résoudre cet inconvénient une méthode de solution selon la technique antérieure a été utilisée pour régler la tension de seuil de déplacement Vts en augmentant la tension de seuil Vts des transistors actifs, de façon à réduire les changements correspondants dans la Vts causés par les charges piégées.

Cette méthode est décrite dans l'article de Pierre Jarron et al.: «Deep submicron CMOS technologies for LHC experiment» - Nuclear Physics B (Proc. Suppl.) 78 (1999) pages 625-634.

Par conséquent, l'effet des charges piégées sur la performance globale des dispositifs à circuits intégrés est minimisé. Cependant, la technique mentionnée n'est pas aussi efficace si on l'applique aux régions d'isolement LOCOS. Bien que la Vt du transistor accessoire des régions d'isolement LOCOS puisse être réglée de façon à ce que le déplacement de la Vt causé par la charge piégée dans l'oxyde épais soit relativement faible, la région d'isolement résultante aura une tension de rupture inacceptablement faible.

Une autre technique connue utilisée pour loger la charge piégée dans une région d'isolement LOCOS épaisse est de créer une structure d'isolement d'oxyde à deux couches.

Une couche relativement mince d'oxyde d'environ 500 .ANG. est accrue dans une région d'isolement, suivie par la formation d'une couche d'oxyde relativement épais d'environ 4000 .ANG. sur la couche d'oxyde relativement mince. L'oxyde dopé avec du phosphore est ensuite soumis à une phase de processus de densification par cuisson.

La structure résultante minimise l'effet des charges positives piégées sur les caractéristiques de dispersion de la région d'isolement neutralisant les charges positives piégées avec l'abondance d'électrons de l'oxyde relativement épais dopé avec du phosphore. Cependant, cette approche est limitée par la concentration de dopant de la couche d'oxyde relativement épais. C'est-à-dire, plus le niveau d'impuretés est grand, plus la diffusion d'impuretés de l'oxyde épais aux couches adjacentes est grande.

Il faut noter que la partie d'une structure MOS étant plus sensible à la radiation ionisante est la couche d'oxyde isolante.

Lorsque la radiation passe à travers l'oxyde, l'énergie déposée crée des paires électron-trou. Les électrons générés par la radiation sont plus mobiles des trous et ils sortent de l'oxyde en une picoseconde environ. En ce moment, une fraction des électrons et des trous se recombine. La quantité de recombination dépend du champ appliqué et du type et de l'énergie de la particule incidente.

Les trous qui échappent la recombination initiale sont relativement immobiles et ils restent près de leur point de génération, causant donc des déplacements négatifs de tension dans les caractéristiques électriques du dispositif MOS. Mais pour une période de temps plus longue, dépassant une seconde, les trous subissent un transport sautillant stochastique assez anomal à travers l'oxyde en réponse à n'importe quel champ électrique présent.

Ce processus de transport des trous provoque une restauration transitoire à court terme du déplacement de tension. Lorsque les trous atteignent l'interface SiO₂ (pour polarisation positive de grille), certains sont capturés en lieux de piégeage à long terme et ils causent un déplacement négatif de la tension résiduelle qui n'est pas sensible au potentiel de surface du silicium, qui peut durer de quelques heures à quelques années.

Le déplacement de tension à long terme causé par la radiation est une forme commune de dommage par radiations dans les dispositifs MOS. Le piégeage à long terme des trous (c'est-à-dire une charge positive nette dans la couche d'oxyde) près de l'interface, de même que leur recuit suivant, est sensible au traitement de l'oxyde et au champ et à la température. Cet effet domine généralement les autres processus d'endommagement des radiations dans les structures MOS.

Plusieurs efforts dans la technique corrélée visaient à réduire et contrôler le piégeage des charges positives d'oxydes. Au début, les circuits MOS insensibles aux radiations avaient des polluants ioniques dans les matières de l'oxyde de grille pour changer et améliorer les propriétés de l'oxyde sous radiation.

Ensuite, les techniques de fabrication des dispositifs MOS et les contrôles du processus dans la technique corrélée avaient été améliorés et donc les techniques de résistance se basant sur l'ajout d'impuretés dans l'oxyde sont devenue impopulaires (au moins pour l'oxyde de grille). La résistance aux radiations à été concentrait donc sur la source primaire de la charge positive d'oxyde générée par la radiation (c'est-à-dire le trou piégé). Une piège à trous indique normalement des défauts de l'oxyde neutre pouvant capter des trous et les garder donc pour de longues périodes de temps.

La génération et le piégeage des trous causés par les radiations sont un problème et dans l'oxyde de grille et dans l'oxyde de champ ou silicium des dispositifs MOS. Les oxydes de champ sont traditionnellement plus épais des oxydes de grille d'un ordre de grandeur. Les propriétés des oxydes de grille ne sont pas aussi bien contrôlées que celles des oxydes de grille.

Dans la technique corrélée, les oxydes de champ peuvent être produits par des processus tels que le dépôt chimique sous vapeur (CVD), pas utilisé pour les oxydes de grille. Les changements de la tension de seuil causés par les radiations sont proportionnels au carré de l'épaisseur de l'oxyde. Par exemple, une dose de radiation relativement faible cause un changement considérable de la tension de seuil dans un transistor à effet de champ (FET) de l'oxyde de champ parasite.

Une telle solution est décrite par exemple dans le brevet US n. 6,063,690 de Woodruff et al. intitulé «Method for making recessed field oxide for radiation hardened microelectronics».

Une plus grande épaisseur de l'oxyde entraîne aussi des champs électriques plus petits dans les oxydes. Les champs plus petits réduisent le rendement de charge et ils augmentent soit la capture des trous soit la recombination électron/trou dans les pièges à trous. Une plus grande épaisseur de l'oxyde augmente aussi le volume de génération de charge et la distance que soit les trous soit les électrons doivent parcourir pour échapper à l'oxyde, qui augmente à son tour le piégeage et la recombinaison. Le résultat net est que les effets d'espace et de recombinaison commencent à dominer le changement du seuil de la tension des oxydes de champ pour des doses de quelques Krad (SiO₂), deux ou trois ordres de grandeur en moins par rapport aux niveaux de radiation qui causent traditionnellement de tels effets dans les oxydes de grilles plus minces.

Et l'augmentation de l'épaisseur de l'oxyde et la diminution dans le champ d'oxyde augmentent aussi considérablement l'échelle des temps du transport des trous à travers l'oxyde. Par conséquent, le transport réel des trous peut avoir lieu dans un oxyde de champ pour des milliers de secondes après soumission aux radiations.

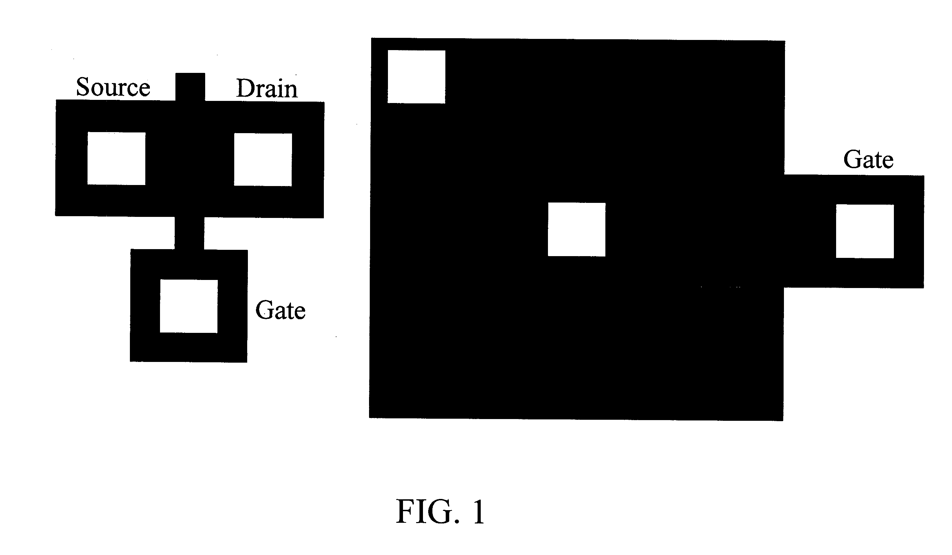

Une autre façon pour éliminer la dispersion causée par l'effet de bec de oiseau [bird beak] utilise certaines configurations MOS innovatrices (voir fig. 1) pouvant éviter le non souhaité chemin de dispersion. Cette étude qui considère le vrai anneau MOS a été menée par le CERN à Genève, elle donne des résultats mais elle ne convient pas au design en terme de zone occupée et vrai calcul W/L.

Le problème technique sur lequel se base la présente invention est de prévoir une structure CMOS résistante aux radiations ayant de telles caractéristiques structurales et fonctionnelles permettant de contrôler les courants de dispersion causés par la région d'isolement, augmentant la durée de vie du dispositif même dans de sévères et extrêmes conditions environnementales de fonctionnement.

En particulier, le problème technique sur lequel se base la présente invention est de contrôler soit le courant de dispersion localisé juste sous la région d'isolement (LOCOS), dénommées dispersions inter-transistors, soit le courant de dispersion sur le marge de la zone active entourant le transistor, dénommées dispersions intra-transistor.

### Résumé de l'invention

L'idée sur laquelle la présente invention se base est de prévoir une structure CMOS résistante aux radiations comprenant un transistor MOS ayant un élément à anneau de garde tout autour de chaque transistor MOS et les régions de bec de oiseau tout autour du transistor sont éloignées de la zone active du transistor MOS.

Les caractéristiques et les avantages du dispositif selon l'invention apparaîtront de la description suivante de ses formes de réalisation, donnée à titre d'exemples non limitatifs avec référence aux dessins annexés.

### Brève description des figures

La Figure 1 est une vue schématique de dessus qui montre une comparaison entre une structure MOS traditionnelle et une structure MOS sans marges [edgeless];
La Figure 2 est une vue schématique en plan de dessus à échelle agrandie d'une structure NMOS obtenue selon la méthode de la présente invention;
La Figure 3 est une vue schématique en coupe transversale à échelle agrandie de la structure NMOS de la figure 2;
La Figure 4 est une vue schématique en plan de dessus à échelle agrandie d'une structure PMOS obtenue selon la méthode de la présente invention;
La Figure 5 est une vue schématique en coupe transversale à échelle agrandie de la structure PMOS de la figure 4.

### Description détaillée

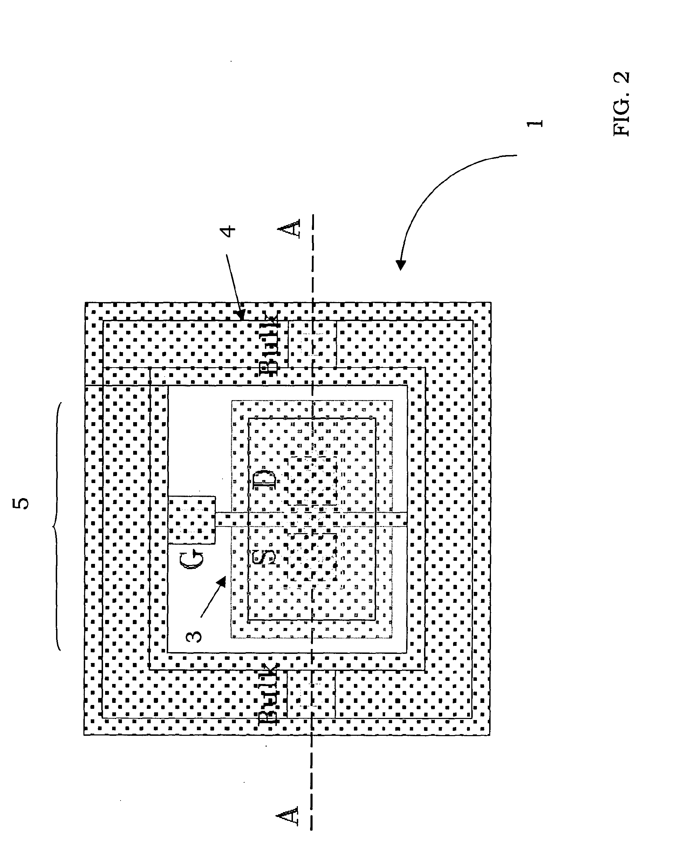

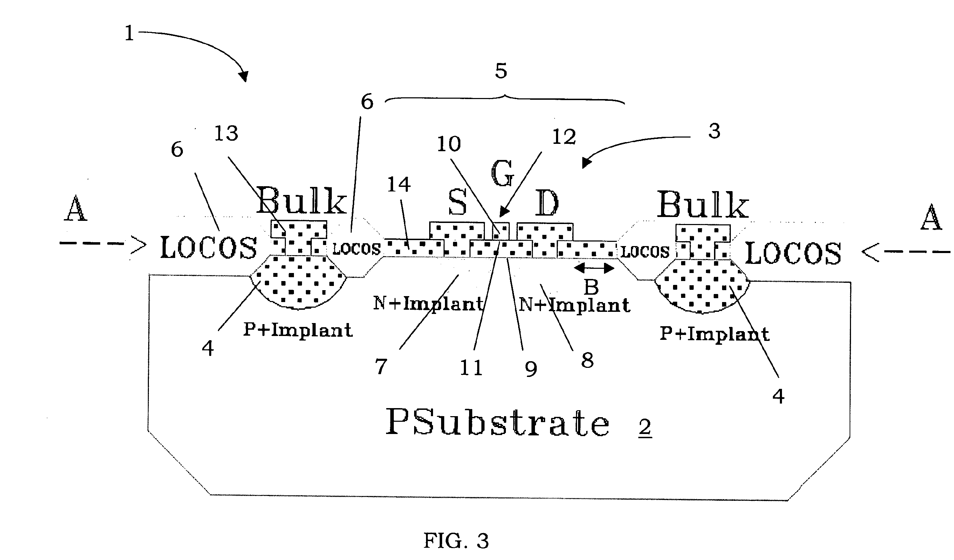

En se référant aux figures 2 à 5, on décrit une structure MOS résistante aux radiations.

Les figures qui montrent des coupes transversales à travers une tranche de semi-conducteur ne sont pas dessinées à l'échelle mais plutôt de façon à mettre en évidence les caractéristiques principales de l'invention.

Selon l'invention, la structure MOS résistante aux radiations 1, intégrée dans un substrat semi-conducteur 2, comprend un transistor MOS 3 et un élément à anneau de garde 4 entourant le transistor NMOS 3.

Le transistor NMOS 3 est formé dans la zone active 5 entourée par une couche d'isolement épaisse 6, par exemple une couche d'oxyde épais du type LOCOS.

Le transistor NMOS 3 comprend une région de drain 7 et une région de source 8, formée par une implantation du type N dans un substrat semi-conducteur 2.

La région du substrat comprise entre les régions de drain 7 et de source 8 forme une région de canal 9 du transistor NMOS 3, qui est couverte par une région de grille 10 d'une façon isolée de ladite région de canal et avec l'interposition d'une couche d'oxyde 11. La région de grille 10 est traditionnellement formée par une couche conductrice 12, par exemple de polisilicium.

Selon l'invention, la structure NMOS résistante aux radiations 1 comprend un élément à anneau de garde 4 prévu à l'extérieur de la zone active 5 sous la couche d'oxyde épais 6. Cet élément à anneau de garde 4 est formé par une implantation du type P dans un substrat semi-conducteur 2.

Avantageusement, au moins une ouverture est formée dans la couche d'oxyde épais 6 alignée avec l'élément à anneau de garde 4 pour former un contact électrique 13.

Cet élément à anneau de garde fonctionne comme un canal d'arrêt entre deux transistors NMOS de façon à ce qu'il n'y ait pas de communication possible entre deux transistors NMOS adjacents. Cette première amélioration du design est une façon efficace choisie pour arrêter les dispersions inter-transistors.

Concernant les dispersions intra-transistor, le but est éviter un allumage anormal du transistor NMOS soumis à la radiation causé par des charges accumulées à l'extrême limite du problème du bec de oiseau.

En particulier, les régions de source 7 et de drain 8 sont éloignées de la couche d'oxyde épais 6.

Par conséquent, les régions de source et drain 7, 8 sont prévues à une distance B de la couche d'oxyde épais 6.

Une couche d'oxyde mince 14 est en suite formée sur le substrat semi-conducteur 2 entre les régions de source et drain 7, 8 et la couche d'oxyde épais 6.

Avantageusement, la couche d'oxyde mince 14 est la même que la couche d'oxyde mince 11.

Par conséquent, les régions à bec de oiseau tout autour du transistor, formées entre la couche d'oxyde épais 6 et la couche d'oxyde mince 14, sont éloignées de la zone active du transistor NMOS.

Avantageusement, pour chaque technologie MOS, une distance B sera optimisée pour atteindre la dose totale prédéterminée visée que la structure 1 devra supporter.

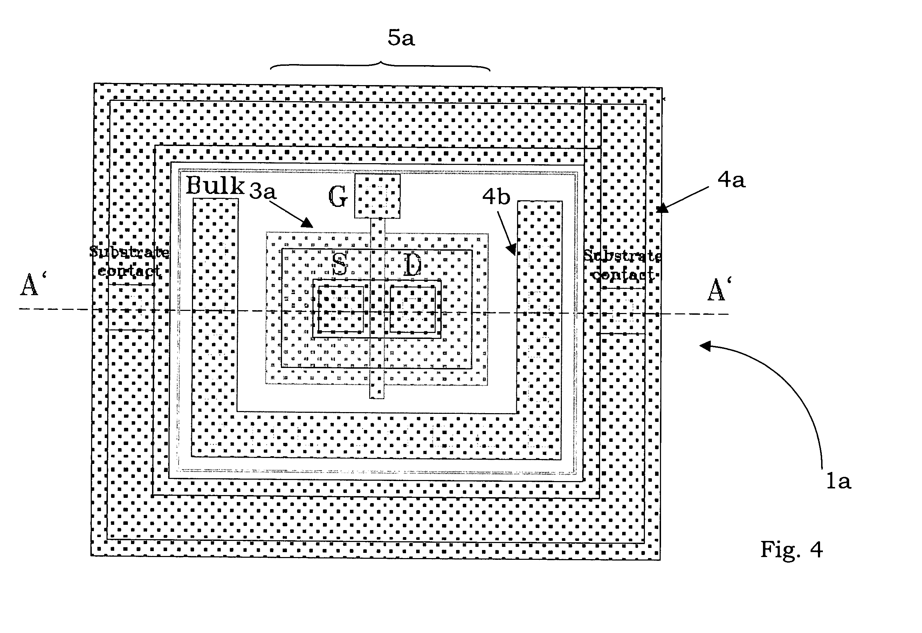

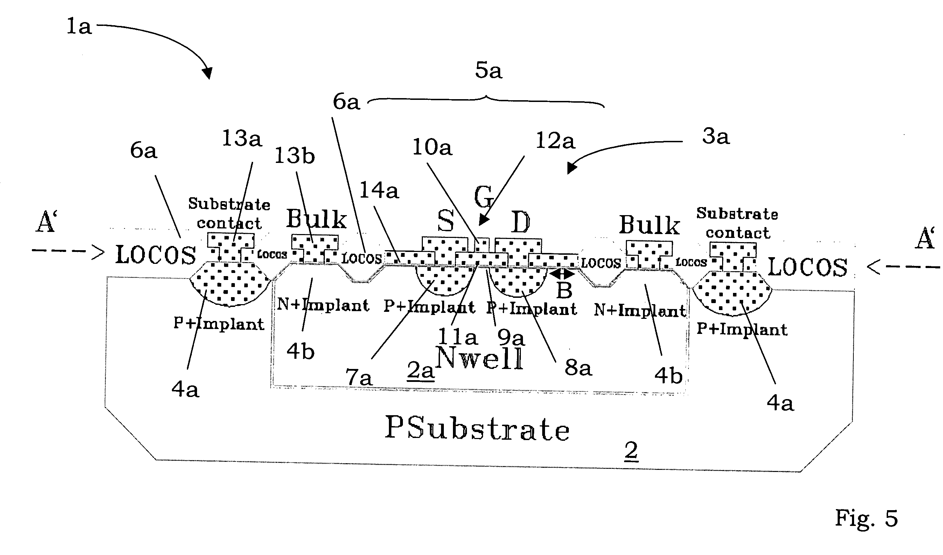

Ces deux solutions concernant des phénomènes physiques sur le comportement aux radiations des structures MOS se produisant sur les transistors MOS ont été mises en oeuvre aussi dans les structures PMOS pour avoir une structure balancée pour les designs des circuits intégrés, comme montré dans les figures 4, 5.

En particulier, on décrit une structure PMOS résistante aux radiations 1a, intégrée sur un substrat semi-conducteur 2.

Un puits N [N-well] 2a est formé dans un substrat semi-conducteur 2, dans lequel on forme un transistor PMOS 3a et un élément à anneau de garde 4a entourant le transistor PMOS 3a.

Le transistor PMOS 3a est formé dans une zone active 5a entourée par une couche d'oxyde épais 6a, par exemple LOCOS.

Le transistor PMOS 3a comprend une région de drain 7a et une région de source 8a, formée par une implantation du type P dans un puits N 2a.

La région du substrat comprise entre les régions de drain 7a et de source 8a forme une région de canal 9a du transistor PMOS 3a, qui est couverte par une région de grille 10a d'une façon isolée de ladite région de canal et avec l'interposition d'une couche d'oxyde 11a. La région de grille 10a est traditionnellement formée par une couche conductrice 12a, par exemple de polisilicium.

Selon l'invention, la structure MOS résistante aux radiations 1a comprend un élément à anneau de garde 4a prévu à l'extérieur de la zone active 5a sous la couche d'oxyde épais 6a. Cet élément à anneau de garde 4a est formé par une implantation du type P dans le substrat semi-conducteur 2.

Avantageusement, au moins une ouverture est formée dans la couche d'oxyde épais 6a alignée avec l'élément à anneau de garde 4a pour former un contact électrique 13a.

Dans cette variante de réalisation aussi, l'élément à anneau de garde 4a fonctionne comme un canal d'arrêt entre deux transistors adjacents.

Avantageusement, les régions de source et drain 7a, 8a sont prévues à une distance B de la couche d'oxyde épais 6a.

Une couche d'oxyde mince 14a est donc formée sur le puits N 2a entre les régions de source et drain 7a, 8a et la couche d'oxyde épais 6a.

Avantageusement, la couche d'oxyde mince 14a est la même que la couche d'oxyde mince 11a.

Par conséquent, les régions à bec de oiseau tout autour du transistor sont éloignées de la zone active du transistor PMOS.

Traditionnellement, le puits N 2a est presque entouré par une jonction 4b formée sous la couche d'oxyde épais 6a. Cette jonction 4b est formée par une implantation du type N dans le puits N 2a. Au moins une ouverture est formée dans la couche d'oxyde épais 6a alignée avec la jonction 4a pour former un contact électrique 13b avec le puits N 2a.

En conclusion, les avantages des structures 1, 1a de la présente invention sont énumérés dans la suite:
- Faible augmentation des zones MOS.
- Pas d'effets capacitifs, et donc pas de modifications du comportement électrique d'une structure MOS résistante aux radiations 1 comparée avec une structure traditionnelle.
- Ajout d'un seul niveau de masque par rapport au MOS traditionnel.
- Traitement des lots Rad-Hard utilisant des flux de processus et des équipements traditionnels, assurant une excellente répétabilité et un excellent comportement sous radiations qui ne seront pas affectés par des fluctuations de processus.

## Revendications

1. Structure MOS résistante aux radiations (1, 1a) sur un substrat semi-conducteur (2) comprenant un transistor MOS (3, 3a) réalisé dans une zone active (5, 5a) entourée par une couche d'isolement (6, 6a), ledit transistor MOS (3, 3a) comprenant:
- une région de canal (9, 9a) délimitée par des régions de source (7, 7a) et drain (8, 8a) opposées;
- une région de grille (10, 10a) formée sur le canal et isolée de celui-ci par une couche d'oxyde mince (11, 11a); ladite structure MOS résistante aux radiations (1, 1a) étant **caractérisée en ce qu'**elle comprend
- un élément à anneau de garde (4, 4a), formé dans ledit substrat semi-conducteur (2) sous ladite couche d'isolement (6, 6a), et
- lesdites régions de source (7, 7a) et drain (8, 8a) sont éloignées de ladite couche d'isolement (6, 6a).

2. Structure MOS résistante aux radiations (1, 1a) selon la revendication 1, **caractérisée en ce que** ledit élément à anneau de garde (4, 4a) est électriquement connecté avec un contact électrique (13, 13a) formé par ladite couche d'isolement (6, 6a).

3. Structure MOS résistante aux radiations (1, 1a) selon la revendication 1, **caractérisée en ce que** une couche d'oxyde mince (14, 14a) est prévue de ladite couche d'isolement (6, 6a) auxdites régions de source (7, 7a) et drain (8, 8a).

4. Structure MOS résistante aux radiations (1, 1a) selon la revendication 1, **caractérisée en ce que** ladite couche d'oxyde mince (14, 14a) est la même que la couche d'oxyde mince (11, 11a).

5. Structure MOS résistante aux radiations (1a) selon la revendication 1, **caractérisée en ce que** ledit substrat semi-conducteur (2) comprend un puits N (2a) dans lequel on forme le transistor PMOS (3a).

6. Structure MOS résistante aux radiations (1a) selon la revendication 1, **caractérisée en ce qu'**elle comprend une jonction (4b) formée dans ledit puits N (2a) sous ladite couche d'isolement (6a).

7. Structure MOS résistante aux radiations (1a) selon la revendication 1, **caractérisée en ce que** ladite jonction (4b) presque entoure ledit transistor MOS (3a).
